# EUROPÄISCHE PATENTSCHRIFT

(11) **EP 1 705 959 B1**
(45) Veröffentlichungstag und Bekanntmachung des Hinweises auf die Patenterteilung: **07.05.2008**
(21) Anmeldenummer: 05102372.9
(22) Anmeldetag: 24.03.2005
(51) Int. Cl.: H05B 33/04

(54) **Elektrolumineszenzelement**
Electroluminescent element
Elemnt electroluminescent

(43) Veröffentlichungstag der Anmeldung: 27.09.2006
(73) Patentinhaber: Schreiner Group GmbH & Co. KG, 85764 Oberschleissheim (DE)
(72) Erfinder: Krumpe, Joachim, 85649 Brunnthal (DE); Otte, Carsten, 80796 München (DE); Narwark, Oliver, Dr., 80636 München (DE)
(74) Vertreter: Kehl, Günther

(56) Entgegenhaltungen:
- EP-A- 0 372 489
- EP-A- 0 505 575
- EP-A- 1 384 571
- DE-A1- 10 321 152
- US-A- 5 670 224

## Beschreibung

Die Erfindung bezieht sich auf ein Elektrolumineszenzelement mit einer lichtdurchlässigen ersten Elektrode, einer Lumineszenzschicht in Form einer durch eine elektrische Wechselspannung (9) aktivierbaren anorganischen Dickschicht, einer zweiten Elektrode und einem Schutzlaminat.

Unter einem "Schutzlaminat" ist eine Schutzschicht zu verstehen, die eine auflaminierte Folie, eine Bedruckung, eine Lackschicht oder ein eventuell selbstklebendes Verbundmaterial mit diesen Bestandteilen aufweist.

Nach dem Stand der Technik (DE 103 21 152 A1) wurden derartige Elektrolumineszenzelemente mit einem möglichst wasserdampfundurchlässigen Schutzlaminat versehen, um das Eindringen von Wasserdampf zu verhindern. Wasserdampfbarriere-Schichten mit einer Wasserdampfdurchlässigkeitsrate kleiner als 0,005 g/m²/24h bei 38°C und 100% relativer Luftfeuchtigkeit wurden zum Schutz der Lumineszenzschicht gegen von außen eindringende Feuchtigkeit vorgeschlagen, um so eine möglichst große Lebensdauer des Elektrolumineszenzelements zu erzielen.

EP- A-0 505 575 schlägt hitzebeständige, feuchtigkeitsresistente Folien mit Wasserdampfdurchlässigkeiten von 0,09 bis 0,22 g/m²/24h bei 50°C und 90% relativer Luftfeuchtigkeit für Elektrolumineszenzelemente vor.

EP-A- 1 384 571 beschreibt ein Laminatmaterial, das als Verpackungsmaterial für Lebensmittel, Nicht-Lebensmittel, Arzneimittel und als Teile von elektronischen Geräten verwendet werden kann. EP-A- 1 384 571 enthält keinen Hinweis, die dort beschriebene Folie als Teil eines Elektrolumineszenzelements zu verwenden.

EP- A-0 372 489 schlägt hitzebeständige, feuchtigkeitsresistente Folien mit Wasserdampfdurchlässigkeiten von 0,03 bis 0,04 g/m²/24h bei 40°C und 90% relativer Luftfeuchtigkeit für Elektrolumineszenzelemente vor.

Der Erfindung liegt die Aufgabe zugrunde, ein Elektrolumineszenzelement der eingangs genannten Art zu schaffen, das sich durch eine große Lebensdauer und Betriebsdauer auszeichnet.

Die Lösung dieser Aufgabe ist im kennzeichnenden Teil des Patentanspruches 1 angegeben.

Es wurde überraschenderweise gefunden, daß die Verwendung von Schutzlaminaten, die eine geringe Wasserdampfdurchlässigkeit aufweisen, die Lebensdauer der anorganischen Elektrolumineszenzelemente, die auf einen Träger aus Polycarbonat gedruckt sind, erhöhen. Dieser überraschende Effekt ist wahrscheinlich darauf zurückzuführen, daß eine in Grenzen wasserdampfdurchlässige Sperrschicht zuläßt, daß Restlösemittel und Feuchtigkeit, die über den Träger aufgenommen wird, auf dem das Elektrolumineszenzelement angebracht ist, austreten können, ohne das Elektrolumineszenzelement zu gefährden, und dennoch das Eindringen von Wasserdampf aus der Umgebung hinreichend effektiv verhindert. Bei sehr guten Dampfsperrschichten hingegen kann Restlösemittel und über den Träger aufgenommene Feuchtigkeit nur sehr schwer wieder aus dem System austreten. Die Verwendung eines Schutzlaminats mit einer Wasserdampfdurchlässigkeit im Bereich zwischen 0,35 g/m²/24h bei 38°C und 100% relativer Luftfeuchtigkeit und 10 g/m²/24h bei 38°C und 100% relativer Luftfeuchtigkeit hat sich dabei als wirksam erwiesen.

Bevorzugt wird ein Schutzlaminat eingesetzt, das eine Wasserdampfdurchlässigkeit im Bereich zwischen 0,5 g/m²/24h bei 38°C und 100% relativer Luftfeuchtigkeit und 5 g/m²/ 24h bei 38°C und 100% relativer Luftfeuchtigkeit aufweist.

Als besonders vorteilhaft hat sich ein Schutzlaminat erwiesen, das eine Wasserdampfdurchlässigkeit im Bereich zwischen 0,8 g/m²/24h bei 38°C und 100% relativer Luftfeuchtigkeit und 2,5 g/m²/24h bei 38°C und 100% relativer Luftfeuchtigkeit aufweist.

Der Erfindung wird nachfolgend anhand von in den Zeichnungen schematisch dargestellten Ausführungsbeispielen näher erläutert. Die Zeichnungen sind nicht maßstabsgetreu. Vielmehr sind die Dicken der Schichten des Elektrolumineszenzelements im Vergleich zu den anderen Abmessungen stark vergrößert gezeichnet.
Figur 1 zeigt eine erste Ausführungsform eines Elektrolumineszenzelements gemäß der Erfindung in Schnittdarstellung;
Figur 2 zeigt eine Ausführungsvariante zu der Ausführungsform gemäß Figur 1;

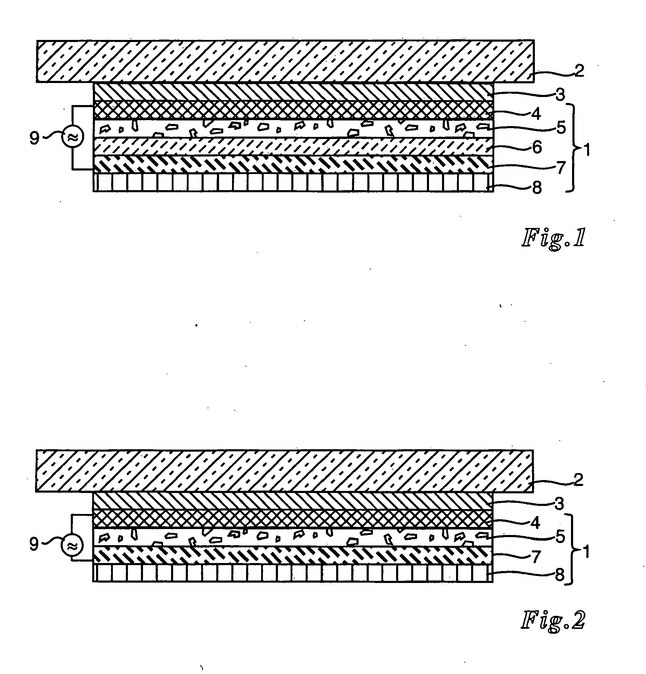

Figur 1 zeigt ein Elektrolumineszenzelement 1 gemäß der Erfindung, das auf einem Kunststoffträger 2 - im Beispiel auf einem im Spritzgußverfahren hergestellten Körper aus Polycarbonat - durch direktes Aufdrucken angebracht ist.

Das Elektrolumineszenzelement 1 weist eine transparente Elektrodenschicht 4 auf, bei der es sich um einen druckbaren Leitlack handelt. Alternativ hierzu kann auch durch Sputtern eine Schicht aus Indium-Zinn-Oxid (ITO) oder Antimon-Zinn-Oxid zur Bildung der Elektrodenschicht 4 erzeugt werden.

Auf die Elektrodenschicht 4 folgt eine Lumineszenzschicht 5, bei der es sich im Beispiel um eine durch Wechselspannung aktivierbare Dickschicht handelt. Diese weist eine Bindermatrix mit eingebetteten anorganischen Luminophoren auf.

Auf die Lumineszenzschicht 5 folgt ein Dielektrikum 6. Bei diesem handelt es sich um eine Schicht aus weißen keramischen Partikeln, die sich durch eine hohe Dielektrizitätskonstante auszeichnen.

Das Dielektrikum 6 ist mit einer Leitschicht aus z. B. Silber, Carbon oder Lack bedeckt, die die zweite Elektrode 7 bildet.

Der Verbundaufbau ist schließlich mit einem Laminat 8 übersiegelt, das eine Wasserdampfdurchlässigkeit im Bereich zwischen 1,3 g/m²/24h bei 38ºC und 100% relativer Luftfeuchtigkeit und 1,9 g/m²/24h bei 38ºC und 100% relativer Luftfeuchtigkeit aufweist. Die Wasserdampfdurchlässigkeit ist ausreichend klein, um den Verbund vor eindringender Feuchtigkeit zu schützen und läßt trotzdem zu, daß Lösungsmittelreste und Ausgasungen aus dem Verbund austreten können.

Die beiden Elektroden 4 und 7 sind elektrisch mit einer Wechselspannungsquelle 9 verbunden, die eine Wechselspannung von 100 Volt mit einer Frequenz von 400 Hertz bereitstellt.

Das Elektrolumineszenzelement 1 wird wie folgt hergestellt:

Auf einen transparenten Träger 2, z. B. ein Spritzgußteil, wird zunächst eine transparente Schicht 3 zur Haftvermittlung und/oder zur Verbesserung des optischen Eindruckes (z.B. im Siebdruck oder als Hardcoat) aufgetragen. Optional kann eine Verbesserung des optischen Eindrucks auch durch zusätzliche Farbschichten, beispielsweise durch eine Metallschicht (grafisches Silber) erreicht werden. Zur Herstellung der transparenten Elektrode 4 wird hierauf eine Schicht eines transparenten Leitlackes (Leiter sind hier vorzugsweise entweder Polymersysteme z.B. dotierte Polythiophene, anorganische Systeme (ITO = Indium-Zinn-Oxid) oder ATO = Antimon-Zinn-Oxid)) gedruckt, welche als transparente Elektrode 4 fungiert. Hierauf werden zur Bildung der Lumineszenzschicht 5 in eine Bindermatrix eingebettete Elektroluminophore im Siebdruckverfahren aufgetragen. Es folgt das Dielektrikum 6, das eine Schicht aus weißen keramischen Partikeln aufweist, welche ebenfalls in eine Bindermatrix eingebettet sind und im Siebdruckverfahren aufgetragen werden. Diese Partikel zeichnen sich durch einen hohen Wert der Dielektrizitätskonstanten aus. Zur Vervollständigung des Kondensatorsystems wird eine weitere elektrisch leitfähige Schicht (z.B. aus Silber, Carbon, Leitlack) aufgetragen, die die zweite Elektrode 7 darstellt. Abgeschlossen wird das System durch eine gedruckte Isolationsschicht (nicht gezeichnet), um den Benutzer vor der anzulegenden Wechselspannung (typischerweise 100 - 160 V und 400 - 800 Hertz) und das Elektrolumineszenzelement 1 vor Feuchtigkeit zu schützen.

Durch die geringe Wasserdampfdurchlässigkeit des Schutzlaminats 8 wird erreicht, daß Feuchtigkeit, die vom lichtdurchlässigen Träger 2 aufgenommen wird, über das Schutzlaminat 8 austreten kann. Ebenso können Ausgasungen und Lösungsmittelreste den Verbund verlassen, ohne die Funktion des Elektrolumineszenzelements 1 zu beeinträchtigen. Gleichzeitig stellt das Schutzlaminat 8 eine wirksame Sperre gegen den Eintritt von Feuchtigkeit dar.

Figur 2 zeigt ein Ausführungsbeispiel eines Elektrolumineszenzelements 1, bei dem kein Dielektrikum vorgesehen ist. Da der sonstige Aufbau des Elektrolumineszenzelements 1 sich nicht von dem des Ausführungsbeispiels der Figur 1 unterscheidet und auch die Herstellungsverfahren - abgesehen von der Weglassung des Schrittes zur Herstellung des Dielektrikums - gleich sind, darf zur Vermeidung von Wiederholungen von einer erneuten Beschreibung abgesehen werden.

## Patentansprüche

1. Elektrolumineszenzelement (1) mit einer lichtdurchlässigen ersten Elektrode (4), einer Lumineszenzschicht (5) in Form einer durch eine elektrische Wechselspannung (9) aktivierbare anorganische Dickschicht, einer zweiten Elektrode (7) und einem Schutzlaminat (8),
**dadurch gekennzeichnet,**
- **daß** das Elektrolumineszenzelement (1) auf ein Kunststoffsubstrat (2) aus Polycarbonat aufgedruckt ist, und
- **daß** das Schutzlaminat (8) eine Wasserdampfdurchlässigkeit im Bereich zwischen 0,35 g/m²/24h bei 38°C und 100% relativer Luftfeuchtigkeit und 10 g/m²/24h bei 38°C und 100% relativer Luftfeuchtigkeit aufweist.

2. Elektrolumineszenzelement (1) nach Anspruch 1, **dadurch gekennzeichnet, daß** das Schutzlaminat (8) eine Wasserdampfdurchlässigkeit im Bereich zwischen 0,5 g/m²/24h bei 38°C und 100% relativer Luftfeuchtigkeit und 5 g/m²/24h bei 38°C und 100% relativer Luftfeuchtigkeit aufweist.

3. Elektrolumineszenzelement (1) nach Anspruch 1, **dadurch gekennzeichnet, daß** das Schutzlaminat (8) eine Wasserdampfdurchlässigkeit im Bereich zwischen 0,8 g/m²/24h bei 38°C und 100% relativer Luftfeuchtigkeit und 2,5 g/m²/24h bei 38°C und 100% relativer Luftfeuchtigkeit aufweist.

4. Elektrolumineszenzelement (1) nach einem der vorhergehenden Ansprüche, **dadurch gekennzeichnet, daß** es eine dielektrische Schicht (6) aufweist.

5. Elektrolumineszenzelement (1) nach einem der vorhergehenden Ansprüche, **dadurch gekennzeichnet, daß** es eine Metallschicht (grafisches Silber) aufweist.

6. Elektrolumineszenzelement (1) nach Anspruch 1, **dadurch gekennzeichnet, daß** das Kunststoffsubstrat (2) ein Spritzgußsubstrat ist.

7. Elektrolumineszenzelement (1) nach Anspruch 6, **dadurch gekennzeichnet, daß** das Kunststoffsubstrat (2) lichtdurchlässig ist.

## Claims

1. Electroluminescent element (1), comprising a transparent first electrode (4), a luminescent layer (5) in the form of an inorganic thick layer which can be activated by an electric alternating voltage (9), a second electrode (7) and a protective laminate (8), **characterised in that**
- the electroluminescent element (1) is imprinted onto a plastics material substrate (2) made of polycarbonate and
- the protective laminate (8) has a water vapour-permeability in the range between 0.35 g/m²/24h at 38°C and 100% relative air humidity and 10 g/m²/24h at 38°C and 100% relative air humidity.

2. Electroluminescent element (1) according to claim 1, **characterised in that** the protective laminate (8) has a water vapour-permeability in the range between 0.5 g/m²/24h at 38°C and 100% relative air humidity and 5 g/m²/24h at 38°C and 100% relative air humidity.

3. Electroluminescent element (1) according to claim 1, **characterised in that** the protective laminate (8) has a water vapour-permeability in the range between 0.8 g/m²/24h at 38°C and 100% relative air humidity and 2.5 g/m²/24h at 38°C and 100% relative air humidity.

4. Electroluminescent element (1) according to any one of the preceding claims, **characterised in that** it has a dielectric layer (6).

5. Electroluminescent element (1) according to any one of the preceding claims, **characterised in that** it has a metal layer (graphic silver).

6. Electroluminescent element (1) according to claim 1, **characterised in that** the plastics material substrate (2) is an injection-moulded substrate.

7. Electroluminescent element (1) according to claim 6, **characterised in that** the plastics material substrate (2) is transparent.

## Revendications

1. - Elément électroluminescent (1), comportant une première électrode transparente (4), une couche luminescente (5) sous la forme d'une couche épaisse anorganique activable par une tension électrique alternative (9), une deuxième électrode (7) et un laminé de protection (8), **caractérisé par le fait**
- **que** l'élément électroluminescent (1) est imprimé sur un substrat de matière plastique (2) en polycarbonate ; et
- **que** le laminé de protection (8) présente une perméabilité à la vapeur d'eau se situant dans la plage entre 0,35 g/m²/24h à 38 °C et 100% d'humidité d'air relative et 10 g/m²/24h à 38 °C et 100% d'humidité d'air relative.

2. - Elément électroluminescent (1) selon la revendication 1, **caractérisé par le fait que** le laminé de protection (8) présente une perméabilité à la vapeur d'eau se situant dans la plage entre 0,5 g/m²/24h à 38 °C et 100% d'humidité d'air relative et 5 g/m²/24h à 38 °C et 100% d'humidité d'air relative.

3. - Elément électroluminescent (1) selon la revendication 1, **caractérisé par le fait que** le laminé de protection (8) présente une perméabilité à la vapeur d'eau se situant dans la plage entre 0,8 g/m²/24h à 38 °C et 100% d'humidité d'air relative et 2,5 g/m²/24h à 38 °C et 100% d'humidité d'air relative.

4. - Elément électroluminescent (1) selon l'une quelconque des revendications précédentes, **caractérisé par le fait qu'**il présente une couche diélectrique (6).

5. - Elément électroluminescent (1) selon l'une des revendications précédentes, **caractérisé par le fait qu'**il présente une couche métallique (argent graphique).

6. - Elément électroluminescent (1) selon la revendication 1, **caractérisé par le fait que** le substrat de matière plastique (2) est un substrat de moulage par injection.

7. - Elément électroluminescent (1) selon la revendication 6, **caractérisé par le fait que** le substrat de matière plastique (2) est transparent.
